Europäisches Patentamt

European Patent Office

Office européen des brevets

(11) Publication number: **0 191 981**
**B1**

(12) EUROPEAN PATENT SPECIFICATION

(45) Date of publication of patent specification: **20.09.89**

(21) Application number: **85308650.2**

(22) Date of filing: **28.11.85**

(51) Int. Cl.⁴: **H 01 L 23/52, H 01 L 21/90**

(54) Multilayer circuit. ·

(30) Priority: **22.01.85 GB 8501579**

(43) Date of publication of application:
**27.08.86 Bulletin 86/35**

(45) Publication of the grant of the patent:
**20.09.89 Bulletin 89/38**

(84) Designated Contracting States:
**AT BE CH DE FR IT LI LU NL SE**

(56) References cited:
**EP-A-0 110 401**

**THIN SOLID FILMS, vol. 53, no. 2, September
1978, pages 195-205, Lausanne, CH; R.S.
NOWICKI et al.: "Studies of the Ti-W-/Au
metallization on aluminum"**

**EXTENDED ABSTRACTS OF THE 15th
CONFRERENCE ON SOLID STATE DEVICES
AND MATERIALS, Supplement to the
JAPANESE JOURNAL OF APPLIED PHYSICS,
1983, pages 233-236, Tokyo, JP; S. SHIMA et al.:
"A new application of Al-Si films coated with
TiSi2 in VLSI multi-level interconnections"**

(73) Proprietor: **MARCONI ELECTRONIC DEVICES
LIMITED
The Grove Warren Lane
Stanmore Middlesex HA7 4LY (GB)**

(72) Inventor: **Harvey, Paul Robert
34, Benson Crescent
Doddington Park Lincoln (GB)**

(74) Representative: **Waters, Jeffrey
The General Electric Company plc Central Patent
Department Marconi Research Centre West
Hanningfield Road
Great Baddow Chelmsford Essex CM2 8HN (GB)**

(56) References cited:
**JOURNAL OF THE ELECTROCHEMICAL
SOCIETY, vol. 131, no. 1, January 1984, pages
123-125, Manchester, US; E.R. SIRKIN et al.: "A
method of forming contacts between two
conducting layers separated by a dielectric"**

**IEEE TRANSACTIONS OF ELECTRON DEVICES,
vol. ED-32, no. 2, pages 174-183, New York, US;
D.S. GARDNER et al."Layered and
homogeneous films of aluminum and
aluminum/silicon with titanium and tungsten
for multilevel interconnects"**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

This invention relates to multilayer electrical circuits and it is particularly applicable to semiconductor devices which carry a number of conductive tracks whose paths intersect each other at multilayer crossovers in which one track is electrically insulated from another by means of an intervening material which serves to support the upper track. It is customary for the upper track to undergo abrupt changes in profile where it crosses over the lower track which is usually formed at the surface of a semiconductor body and these abrupt changes in profile can render it difficult to manufacture tracks and multilayer interconnections in a reliable manner. It has been found that if the upper track is defined by means of a selective etching technique then the conductive material on the shoulders of the abrupt changes in profile may not be completely removed, thereby resulting in undesired short circuits. [Reference should be made to the Japanese Journal of Applied Physics (1983) 15th Conference, pages 233 - 236].

The present invention seeks to provide an improved multilayer circuit and a semiconductor device incorporating such an interconnection.

According to a first aspect of this invention, a multilayer electrical circuit includes a substrate carrying a first conductive layer of aluminium; and an overlying layer in contact therewith, said overlying layer includes tungsten and titanium so as to inhibit the formation of temperature dependent nodules therein; a silicon oxide deposition overlying said layer so as to follow its contours and having a planar outer surface; and a further conductive layer overlying said outer surface.

According to a second aspect of this invention, a semiconductor arrangement includes a body of silicon having at a surface thereof a first aluminium conductor including a proportion of titanium, or having an overlying metallic layer which includes titanium and tungsten in contact with the aluminium conductor so as to inhibit the formation of temperature dependent nodules in the aluminium; a silicon oxide deposition overlying at least part of said conductor, the surface of the oxide deposition remote from said body of silicon, being of a planar nature; and further aluminium conductor overlying said outer surface.

Preferably a layer of a material containing tungsten and titanium is placed over the aluminium prior to the formation of the silicon oxide covering. Of necessity, the silicon oxide is formed at a fairly high temperature, even though the deposition process is sometimes referred to as a low temperature oxidisation as it is performed at about the temperature of 420°C, which is very much lower than the temperature at which thermally grown oxide is produced. The coating of the titanium and tungsten material prevents or inhibits the formation of nodules in the aluminium during the relatively high temperature step in which the silicon oxide is deposited. These nodules take the form of raised projections standing proud of the upper surface of the aluminium, and are commonly formed in the absence of a covering layer of the material specified.

Titanium may be included in the aluminium, which is present at the surface of the body of silicon in order to inhibit the nodules, but such a process is not preferred in view of the additional complexity of introducing the titanium into the aluminium. It is therefore preferred to provide the coating of tungsten and titanium as a separate step following the formation of the first conductive layer of aluminium, which itself may well be defined by means of a selective etching process. Preferably the inhibiting coating consists in the main of tungsten with a contribution of titanium of about 10%.

According to a third aspect of this invention a method of making a multilayer circuit for a semiconductor arrangement includes the steps of: forming a localised track of aluminium at the surface of the device; coating at least part of said track with a material which inhibits the formation of temperature dependent nodules in the aluminium, said coating includes tungsten and titanium; forming thereover a layer of silicon oxide at a raised temperature; providing an overlying material which fills any recesses and depressions in the upper surface of the silicon oxide so as to form a relatively flat surface; removing part of said overlying material with part of said oxide layer to leave a thinner layer of oxide having a relatively flat planar surface; and forming a conductive region of aluminium on the surface of the said thinner layer of oxide.

The layer of silicon oxide is made initially much thicker than would otherwise be the case so that when portions of it are removed, together with said overlying material, a sufficient thickness of the oxide remains so as to provide an electrical insulation between the two regions of aluminium.

The invention is further described by way of example with reference to the accompanying drawings in which:

Figure 1 shows a conventional multilayer circuit, and

Figures 2 and 3 show steps in the formation of a multilayer circuit in accordance with the present invention.

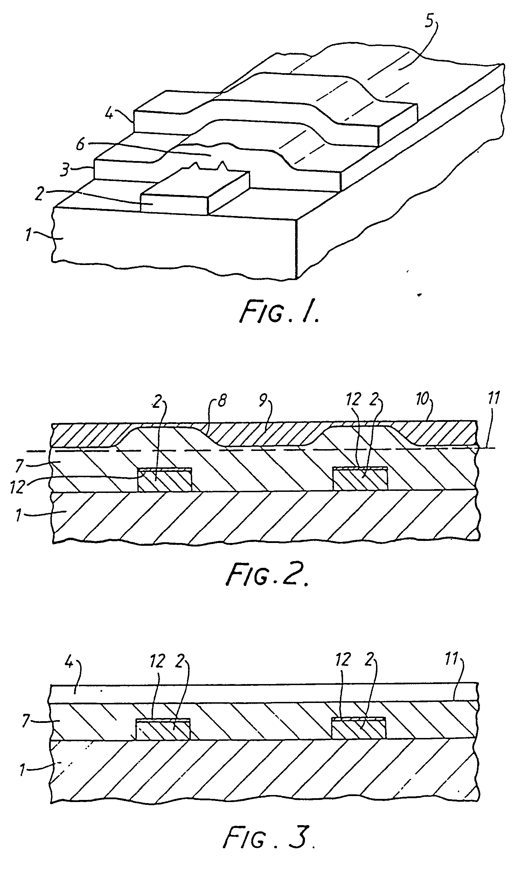

Referring to Figure 1, a body of silicon 1 in which one or more semiconductor devices (not shown) have been formed is provided with a localised track 2 of aluminium on its upper surface. The track 2 can be formed by any convenient means and typically a continuous sheet of aluminium is initially sputtered at a temperature of about 400°C on to the upper surface of the silicon body 1 after which regions of it are selectively removed by an etchant to leave a track having the required profile and disposition. In practice many such tracks having intricate paths can be provided to link the semiconductor devices. A layer of silicon oxide 3 is then formed over the conductive track and although the oxide may be formed by what is conventionally termed a low temperature process, i.e. it is deposited from a vapour rather than grown thermally from the body of silicon, the process proceeds at an elevated temperature of about 420°C. Such a temperature can produce nodules in the upper surface of the aluminium, but the process proceeds only for a very short time and overall the upper surface of the oxide tends to follow undulations due to the nodules in the aluminium. These nodules take the form of localised raised portions projecting above the surface of the aluminium. On top of the silicon oxide is produced a continuous layer of aluminium which is then selectively etched to leave a further conductive track 4 of aluminium, in this case at right angles to the first track 2, and it will be seen that both the upper surface of the oxide and the track 4 follow contours introduced by the presence of the track 2. It has proved difficult to reliably and economically remove those portions of the upper layer of aluminium to leave tracks in the required position as in practice thin strips of aluminium tend to remain on the shoulders 5 of the undulations thereby causing short circuits with adjacent conductive tracks, formed from the same layer. Such an effect can significantly reduce the manufacturing yield of semiconductor devices having many conductive tracks in close proximity to each other.

The present invention provides an improved multilayer interconnection in which this disadvantage is largely removed. Referring to Figures 2 and 3, there are shown therein sectional views representing steps in the production of a multilayer interconnection which is formed in accordance with the invention. As before, tracks 2 are formed on the surface of a semiconductor body 1 of silicon. A thin coating 12 of a material consisting of titanium and tungsten is provided over the aluminium tracks 2. This coating is formed by a sputtering process. The effect of this coating is to inhibit or prevent the formation of nodules on the surface of the aluminium when the tracks and the otherwise open regions of the semiconductor body 1 are covered with a thick oxide layer 7. This oxide layer is an oxide of silicon and is again formed typically by a low temperature vapour deposition process at about 420°C. However, in this case, it is necessary for the oxide to be produced to a much thicker extent than the layer of oxide 3 shown in Figure 1, for reasons which will subsequently be apparent.

The upper surface of the oxide layer 7 contains undulations 8 which correspond generally to and conform with the disposition of the aluminium tracks 2. These recesses and other minor depressions are filled by means of a photoresist material 9 which is spun on to the upper surface of the oxide. That is to say the material 9 is applied in liquid form after which the semiconductor body is rotated rapidly so as to spread a layer of the resist having a flat upper surface 10, which covers the peaks of the oxide. In this instance, the photoresist is used as a convenient filler material, and not for its etchant properties. The photoresist and the silicon oxide are subsequently etched using a plasma technique. In this technique the body of silicon is placed in an evacuated chamber, and chlorine and fluorine gas are passed through the chamber whilst the gas is ionized to form a plasma. The ionized plasma combines with the exposed surfaces to remove the resist and the low temperature oxide at a uniform rate. This process is continued until the upper surface of the arrangement is constituted by the line 11, that is to say, after all of the photoresist 9 has been removed. It will be appreciated that there is relatively little thickness of oxide remaining over the aluminium track 2 and it is for this reason that it is neccesary to inhibit the growth of nodules. Any large nodules which were formed at the surface of the track 2 would be exposed when the oxide thickness is reduced by etching, thereby causing a short circuit to any subsequent layer of conductive material.

Subsequently, conductive tracks 4 are formed transversely to the original tracks 2, the new tracks 4 being in this example, at right angles to the original tracks. These tracks 4 are formed of aluminium in a manner similar to tracks 2. A continuous coating of aluminium is sputtered at about 400° on to the planar surface of the silicon oxide, after which regions of the coating are etched using an etch resistant mask formed in a conventional manner. The aluminium is readily and completely etched, as the aluminium is now removed from a flat surface, so there is no longer a risk of leaving slivers of aluminium in regions which are difficult to etch.

## Claims

1. A multilayer electrical circuit including a substrate (1) carrying a first conductive layer (2) of aluminium; and an overlying layer (12) in contact therewith, said overlying layer including tungsten and titanium so as to inhibit the formation of temperature dependent nodules in the first conductive layer; a silicon oxide deposition (7) overlying said layer so as to follow its contours and having a planar outer surface (11); and a further conductive layer (4) overlying said outer surface.

2. A semi-conductor arrangement including a body of silicon having at a surface thereof a first aluminium conductor (2) including a proportion of titanium or having an overlying metallic layer, (12) which includes titanium and tungsten, in contact with the aluminium conductor, so as to inhibit the formation of temperature dependent nodules in the aluminium; a silicon oxide deposition (7) overlying at least part of said conductor (2), the surface of the oxide deposition (11) remote from said body of silicon, being of a planar nature; and a further aluminium conductor (4) overlying said outer surface.

3. An arrangement as claimed in claim 2 and wherein the metallic layer (12) is localised to conform to the area profile of the first aluminium conductor (2).

4. An arrangement as claimed in claim 3, and wherein the ratio of tungsten to titanium is about 10 to 1.

5. A method of making a multilayer circuit for a semiconductor arrangement including the steps of: forming a localised track of aluminium (2) at the surface of the device; coating at least a part of said track with a material which inhibits the formation of temperature dependent nodules in the aluminium, said coating including titanium and tungsten; forming thereover a layer of silicon oxide (7) at a raised temperature, providing an overlying material (9) which fills any recesses and depressions in the upper surface of the silicon oxide (8) so as to form a relatively flat surface (10); removing said overlying material with part of said oxide layer to leave a thinner layer of oxide having a relatively flat planar surface (11); and forming a conductive region of aluminium (4) on the surface of the said thinner layer of oxide (7).

6. A method as claimed in claim 5 and wherein said overlying material (9) is a photoresist material which is applied as a fluid.

7. A method as claimed in claim 6, and wherein the photoresist material and said oxide are removed by an etching process to leave the thinner layer of oxide.

**Patentansprüche**

1. Elektrische Mehrschichtschaltung mit einem Substrat (1), das eine erste Leitschicht (2) aus Aluminium trägt; und einer darüberliegenden Schicht (12) in Berührung mit dieser, wobei die darüberliegende Schicht Wolfram und Titan enthält, um so die Ausbildung von temperaturabhängigen Knötchen in der ersten Leitschicht zu hindern; eine die Schicht überdeckende Siliziumoxidablagerung (7) in der Weise, daß ihren Konturen gefolgt wird, mit einer planaren Außenfläche (11); und einer weiteren Leitschicht (4), die die äußere Fläche überdeckt.

2. Halbleiteranordnung mit einem Körper aus Silizium, der an einer Oberfläche einen ersten Aluminiumleiter (2) besitzt mit einem Anteil aus Titan oder mit einer darüberliegenden Metallschicht (12), welche Titan und Wolfram enthält, in Berührung mit dem Aluminiumleiter, um so die Ausbildung von temperaturabhängigen Knötchen im Aluminium zu hindern; einer Siliziumoxidablagerung (7), die mindestens einen Teil des Leiters (2) überdeckt, wobei die von dem Siliziumkörper abgelegene Oberfläche (11) der Oxidablagerung planarer Natur ist; und einem weiteren, die Außenfläche überdeckenden Aluminiumleiter (4).

3. Anordnung nach Anspruch 2 und bei der die Metallschicht (12) lokalisiert ist, angepaßt dem Flächenprofil des ersten Aluminiumleiters (2).

4. Anordnung nach Anspruch 3, bei der das Verhältnis Wolfram zu Titan etwa 10 zu 1 beträgt.

5. Verfahren zur Herstellung einer Mehrschichtschaltung für eine Halbleiteranordnung mit den Schritten: Ausbilden einer lokalisierten Aluminiumbahnspur (2) an der Oberfläche des Bauelementes; Beschichten mindestens eines Teiles der Bahnspur mit einem Material, das die Ausbildung von temperaturabhängigen Knötchen im Aluminium hindert, wobei die Beschichtung Titan und Wolfram enthält; Ausbilden einer Schicht aus Siliziumoxid (7) darüber bei einer angehobenen Temperatur, Schaffen eines überdeckenden Materials (9), das etwaige Einschnitte und Vertiefungen in der oberen Fläche des Siliziumoxides (8) ausfüllt, um so eine relativ ebene Fläche (10) zu bilden; Entfernen des überdeckenden Materials mit einem Teil der Oxidschicht, um eine dünnere Oxidschicht mit relativ ebener planarer Oberfläche (11) zurückzulassen; und Ausbilden eines Leitbereiches aus Aluminium (4) auf der Oberfläche der dünneren Oxidschicht (7).

6. Verfahren nach Anspruch 5 und bei dem das überdeckende Material (9) ein Photoresist-Material ist, welches als Fluid aufgebracht wird.

7. Verfahren nach Anspruch 6 und bei dem das Photoresistmaterial und das Oxid durch einen Ätzvorgang entfernt werden, um die dünnere Oxidschicht zurückzulassen.

**Revendications**

1. Circuit électrique multicouche comportant un substrat (1) qui porte une première couche conductrice (2) d'aluminium; et une couche de recouvrement (12) en contact avec celle-ci, cette couche de recouvrement comportant du tungstène et du titane de manière à empêcher la formation de nodules dépendant de la température dans la première couche conductrice; un dépôt d'oxyde de silicium (7) recouvrant ladite couche de manière à suivre son contour et possédant une surface externe plane (11); et une couche conductrice supplémentaire (4) recouvrant ladite surface externe.

2. Ensemble semiconducteur comportant un corps d'aluminium qui possède à sa surface un premier conducteur d'aluminium (2) comportant une certaine proportion de titane ou possédant une couche métallique de recouvrement (12), qui contient du titane et du tungstène, en contact avec le conducteur d'aluminium, de manière à empêcher la formation de nodules dépendant de la température dans l'aluminium; un dépôt d'oxyde de silicium (7) recouvrant au moins une partie dudit conducteur (2), la surface du dépôt d'oxyde (11) qui est à l'opposé dudit corps de silicium ayant une nature plane; et un conducteur d'aluminium supplémentaire (4) recouvrant ladite surface externe.

3. Ensemble selon la revendication 2, où la couche métallique (12) est localisée de manière à se conformer au profil de surface du premier conducteur d'aluminium (2).

4. Ensemble selon la revendication 3, où le rapport du tungstène au titane est d'environ 10 à 1.

5. Procédé de fabrication d'un circuit multicouche pour ensemble semiconducteur, comportant les opérations suivantes: on forme une ligne localisée d'aluminium (2) à la surface du dispositif; on revêt au moins une partie de ladite ligne à l'aide d'un matériau qui empêche la formation de nodules dépendant de la température dans l'aluminium, ledit revêtement comportant du titane et du tungstène; on forme au-dessus une couche d'oxyde de silicium (7) à une température élevée; on établit un matériau de recouvrement (9) qui remplit tous les évidements et tous les creux (8) se trouvant dans la surface supérieure de l'oxyde d'aluminium de manière à former une surface relativement plate (10); on retire ledit matériau de recouvrement avec une partie de ladite couche d'oxyde afin de laisse une couche d'oxyde plus mince ayant une surface plane relativement plate (11); et on forme une région conductrice d'aluminium (4) à la surface de ladite couche d'oxyde (7) amincie.

6. Procédé selon la revendication 5, où ledit matériau de recouvrement (9) est un matériau photosensible de type réserve qui est appliqué sous forme de fluide.

7. Procédé selon la revendication 6, où on retire le matériau photosensible et ledit oxyde par un processus de gravure de manière à laisser une plus faible épaisseur pour la couche d'oxyde.

FIG. 1.

FIG. 2.

FIG. 3.

1